# EUROPEAN PATENT SPECIFICATION

(11) **EP 2 106 205 B1**
(45) Date of publication and mention of the grant of the patent: **11.01.2017**
(21) Application number: 09002127.0
(22) Date of filing: 16.02.2009
(51) Int. Cl.: H05K 7/14, H05K 7/20

(54) **Ruggedized, self aligning, sliding air seal for removable electronic units**
Widerstandsfähige, selbstausrichtende Schieberluftdichtung für abnehmbare elektronische Einheiten
Joint d'étanchéité à l'air durci et à alignement automatique pour unités électroniques amovibles

(30) Priority: 06.03.2008 US 34300 P; 01.04.2008 US 60719
(43) Date of publication of application: 30.09.2009
(73) Proprietor: Northrop Grumman Systems Corporation, Los Angeles, CA 90067 (US)
(72) Inventor: Biemer, Michael G., Linthicum, MD 21090 (US); Konsowski, Stephen C., Linthicum, MD 21090 (US); Haas, Tiffani, Linthicum, MD 21090 (US); Krywicki, Jason, Linthicum, MD 21090 (US)
(74) Representative: Müller Hoffmann & Partner

(56) References cited:
- US-A- 4 277 815
- US-A- 4 375 290
- US-A- 4 442 475
- US-A- 5 034 852
- US-A1- 2006 133 033

## Description

### Background of the Invention.

### 1. Technical Field.

The invention relates to the field of air seals, and more particularly to an air seal and retention system between an equipment housing and a removable module to deliver cooling air across or through electrical components mounted with the removable module.

### 2. Background Art.

High power dissipating electronic assemblies require cooling air to be directed through a compact heat exchanger. This usually consists of a pair of printed circuit boards which may be bonded, or more likely fastened together by means of a frame positioned between the two modules. It is necessary to provide a reliable seal at each end of these modules to prevent leakage of any cooling air between the electronics rack and the removable module. Such leakage can have drastic effect on the system's thermal performance and overall reliability.

It is desirable to have an air seal between an electronics rack and the removable electronics module that also provides a means to ensure low deflections during vibration through use of a fixed boundary condition. It is also desirable to have a sealing system which is resistant to jamming and misalignment and conducive to maintenance and repair. It is further preferred to have a sliding air seal which is cost effective and resistant to corrosive environmental conditions.

Known systems for air cooling of removable electronic units use an elastomeric seal which is vulcanized into a channel shaped guide. This has proven to be a difficult method to manufacture the seal. The present invention vulcanizes the resilient seal to a flat, tapered surface which reduces cost, tooling, and manufacturing complexity.

Known systems for air cooling of removable electronic units also use silicone as the material for the seals which are damaged by exposure to solvents and petro-chemical agents. The new invention uses a double layer of fluorosilicone material or other environmentally resistant material having two durometer values with one on top of the other, and enclosing the slotted opening that is coated with a low friction material on the upper elastomeric material to facilitate low sliding friction when an electronics module having a tapered surface is slid over and compresses the seal.

The known systems for air cooling of removable electronic units utilize difficult to manufacture airseals that are difficult to field replace and are not resistant to chemical environments. The seal of the present invention also has a novel retention method that uses a tab on the bottom (m) and only requires one fastener at the top allowing the seal to be easily field replaceable.

Historically, all airborne radar systems have used classic multiple stage vibration isolation systems to minimize undesirable motion to meet phase noise performance requirements, e.g.,3 stages for AWACS, APG-68, and B1-B. It has been shown that excessive motion during vibration has been determined to be the root cause of phase noise problems in legacy radar systems.

Advances in electronic component technology has resulted in stiffer, higher frequency module structures. (Stiffer means less displacement for a given input.) The development of a wedgelock for use on RF modules was launched in the early 1980's. Wedgelock technology has been part of the solution to high vibration environments and has been used successfully to restrain RF modules on all programs commencing with the APG-68 and B1-B radar systems.

Such sealing methods for printed circuit modules cooled by a flow of air include, for example, U.S. Patent Number 4,375,290, issued March 1, 1983 to Alfred A. Zucchi et al*.* Other examples for background purposes are U.S. Patent Numbers. 2,843,806, 3,956,673, 4,006,388, and 4277815.

US 2006/0133033 A discloses an apparatus for housing and cooling circuit card assemblies employed in communication and other systems including a chassis having opposed end walls which are formed with a series of spaced inlet card guides and correspondingly spaced outlet card guides, respectively. A straight-pass heat exchanger is directly mounted to each circuit card assembly via thermally conductive material, and opposed ends of the heat exchanger are mounted by a wedge lock to respective inlet and outlet card guides. The heat exchanger employs unique and angled interface geometry that creates a gasketless airtight joint with complimentary inlet and outlet card guide geometry through which cooling air passes.

While the above cited references introduce and disclose a number of noteworthy advances and technological improvements within the art, none completely fulfills the specific objectives achieved by this invention. This is achieved by the subject matter of the independent claims.

### Disclosure of Invention.

An electronics housing system adapted for electronic devices includes a main chassis unit and at least one removable module mountable with the base unit for supporting electronic circuitry components electrically or electro-optically coupled with the base unit. The removable module assembly has a main body that includes two opposing mounting edges and an electrical connection edge along the bottom. Both of the vertical mounting edges of the removable mounting assembly or wall of the electronics rack have a slotted opening. One side acts to supply the cooling air flow into an interior cavity of the removable module assembly. The opposing side of the rack has an opening to receive the exhaust of the cooling air from the removable module.

The main chassis unit has a pair of separated and opposing module mounting assemblies or walls of the electronics rack adapted to receive and secure a removable module between the latter opposing module mounting assemblies or walls. Each wall of the electronics rack supporting the electronics module contains an air deliver plenum. One plenum is a pressurized supply for the cooling air and the opposite side wall of the chassis collects and expends the exhaust cooling air. The electronics rack further includes a removable seal plate member having a base plate for securing to the electronics rack and an affixed elastomeric and resilient seal member surrounding an opening formed through the base plate and extending from a surface of the base plate. The seal member then forms a sealing air dam or duct about the cooling air entry and exhaust slots communicated through the cooling air inlet slots of the electronics rack.

The module mounting assembly or wall of the electronics rack or main chassis housing also includes a pair of guide rails extending from the module mounting assembly or wall forming a U-shaped channel between the pair of guide rails for receiving one of the mounting edges of the removable module assembly.

The guide system of the present invention has two surfaces extending beyond the sealing surface of the electronics module providing protection for that sealing surface from objects that could damage the surface. These extensions provide a physical stop that prevents large objects from striking the sealing surface. In addition, the guides are extended so that they are a constant distance from the electronics module thus reducing the "rocking" that jammed the prior known sealing methods for printed circuit modules cooled by a flow of air.

The present invention reduces the frequency of failed installation of the module into the rack with the improved guide system. The present invention further improves the life expectancy of the module connector with the addition of a wedgelock to provide a fixed boundary condition at the module-rack interface. The air seal occupies less volume thus allowing for smaller rack designs. The fluorosilicone seal as described is also resistant to a broader range of petrochemicals and solvents.

These and other objects, advantages and preferred features of this invention will be apparent from the following description taken with reference to the accompanying drawings, wherein is shown the preferred embodiments of the invention.

### Brief Description of Drawings.

A more particular description of the invention briefly summarized above is available from the exemplary embodiments illustrated in the drawing and discussed in further detail below. Through this reference, it can be seen how the above cited features, as well as others that will become apparent, are obtained and can be understood in detail. The drawings nevertheless illustrate only typical, preferred embodiments of the invention and are not to be considered limiting of its scope as the invention may admit to other equally effective embodiments.

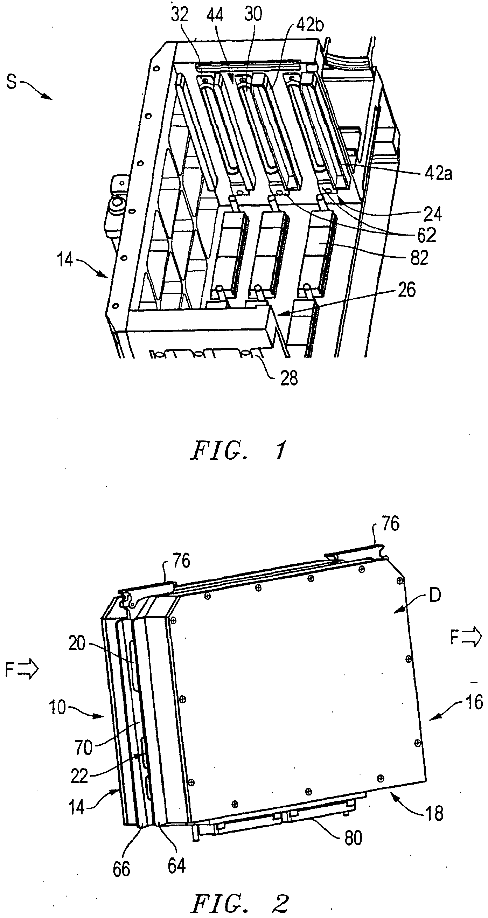

Figure 1 is a perspective view of the interior of the main chassis unit of the housing assembly with no removable modules installed.
Figure 2 is a left frontal elevational view of a removable module.

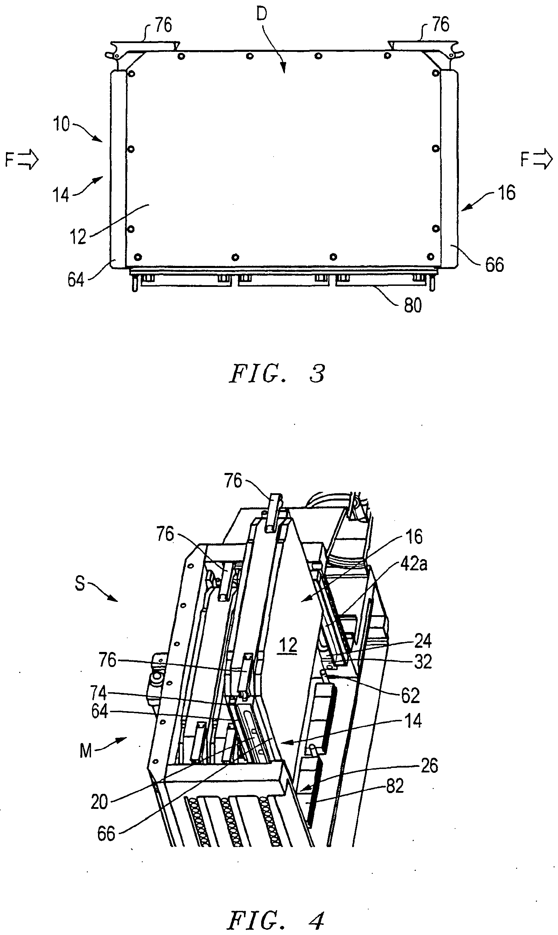

Figure 3 is a left side elevational view of the removable module of Fig. 2.
Figure 4 is a perspective view of the interior of the main chassis with one removable module being positioned.

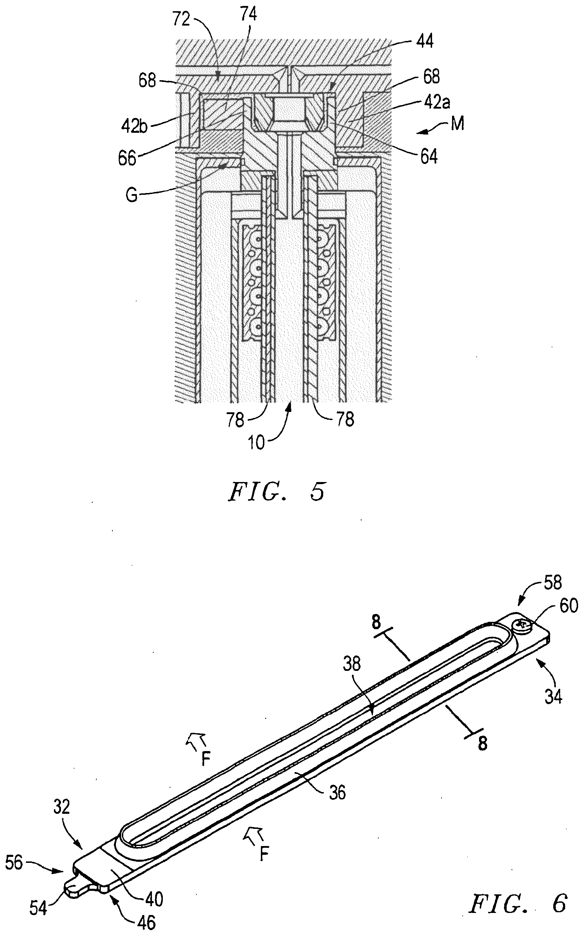

Figure 5 is a cross-sectional view of a removable module installed into an electronic chassis.
Figure 6 is a perspective view of the seal plate member of the present invention.
Figure 7 is a right frontal elevational view of a removable module having a wedgelock type of latching mechanism.
Figure 8 is a cross-sectional view taken along line 8-8 in Figure 6.

### Mode(s) for Camping Out the Invention.

So that the manner in which the above recited features, advantages and objects of the present invention are attained can be understood in detail, more particular description of the invention, briefly summarized above, may be had by reference to the embodiment thereof that is illustrated in the appended drawings. In all the drawings, identical numbers represent the same elements.

An electronics housing system **S** adapted for electronic devices **D,** such as radios, radars, transmitters, and the like, includes a main chassis unit or electronics rack

**M** and at least one compatible and controllably removable module assembly **10** mountable with the base unit or electronic rack **M** for supporting electronic circuitry components, such as a printed circuit board **78,** electrically or electro-optically coupled with the base unit **M** with cooperating connectors **80** and **82.**

The removable module assembly **10** has a main body **12** that generally includes two opposing, vertical mounting edges **14, 16** and a connection edge **18.** At least one of the mounting edges **14,16** of the removable mounting assembly **10** has an opening **20** to vent by receiving or passing a cooling air flow **F** into or from an interior cavity **22** of the main body or housing **12** of the removable module assembly **10.** The cooling air flow F is to flow across the electronic circuitry within the removable module assembly **10** and provide a cooling environment. The air flow **F** can exit the interior of the removable module assembly **10** either through a portion of the opening **20** if there is a U-shaped air flow path within the module **10** or else be vented through another opening in an opposite mounting edge **16** or other vents formed in the main body **12** of the module **10.**

The electronic rack or main chassis unit **M** has at least one and preferably a pair of separated and opposing module mounting assemblies or walls **24, 26** adapted to receive and secure a compatible removable module **10** with a single module mounting assembly or wall **24** or between the opposing module mounting assemblies or walls **24, 26.** At least one of the pair of the opposing module mounting assemblies or walls **24, 26** of the electronics rack **M** includes a plenum means **28** having an opening **30** for communicating the cooling air flow **F** to provide a cooling environment for the electronics contained within the removable module **10.**

The module mounting wall or assembly **24, 26** of the main chassis unit **M** further includes a removable seal plate member **32** having a base plate **34** for securing to the module mounting wall or assembly **24, 26** and an affixed elastomeric and resilient seal member **36** surrounding an opening **38** formed through the base plate **34** and extending from a surface **40** of the base plate **34.** The seal member or rubber bellows **36** forms a sealing air dam or duct about the cooling air flow **F** communicated through the plenum **28** of the module mounting assembly **24, 26.**

The module mounting assembly **24,26** also includes a pair of guide rails **42a, 42b** extending from the module mounting assembly **24, 26** forming a U-shaped channel **44** between the pair of guide rails **42a, 42b** for receiving one of the mounting edges **64, 66** of the removable module assembly **10.** The U-shaped channel **44** is preferably sized to be compatible for receiving the corresponding mounting edge **64, 66** of the module **10.**

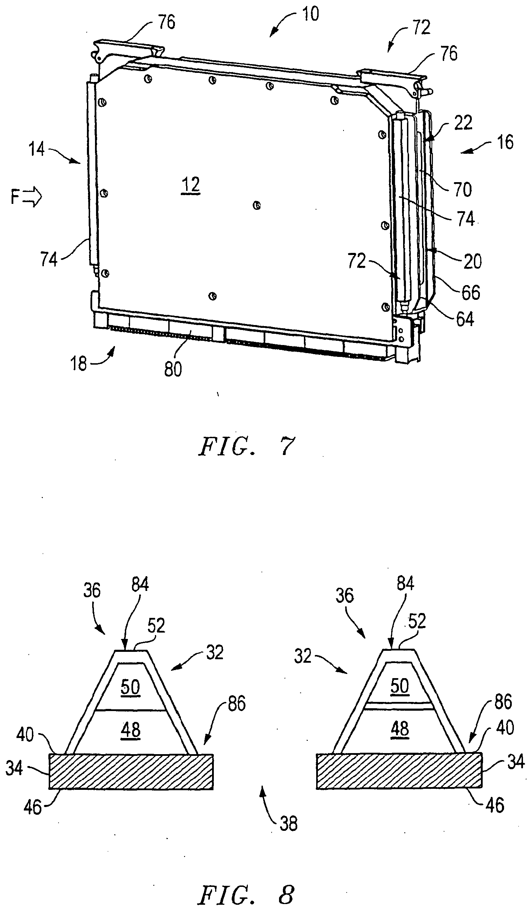

The sliding air seals **36** must work under a variety of conditions. The air seals **36** must operate in a wide variety of temperatures and exposure to corrosive materials. They also must resist tearing when the electronics module **10** is installed and not fail under compressive loads. The optionally removable seal plate member **32** incorporates a metal base plate **34** having a slot opening **38** for the air passage **F** down the center and an inclined upper surface **40** with respect to a lower surface **46;** a double layer of elastomeric material **48, 50** having two durometer values, layered one on top of the other, that may be either fully or partially coated with a low friction material **52,** such as Teflon® or the like, on at least a portion of the upper elastomeric material **50** to facilitate low friction when an electronics module **10** having a mating tapered surface **70** is slid over and compresses the seal **36.** In a preferred embodiment of the slidable seal **36,** the elastomeric material **48, 50** is formed having a tapered cross-section as shown in Fig. 8 with the top of the seal **84** in cross section being narrower than the base of the seal **86,** and the sides in cross section sloping from the seal top **84** toward the wider seal base **86.**

The rubber bellows or air seal member **36** may be vulcanized to the metal frame or plate member **34.**

The known cooling systems for removable electronic units **10** also use silicone as the material for the seals that can be damaged by exposure to solvents and petrochemical agents. The present invention addresses this shortcoming by using new materials, such as a double layer of fluorosilicone material or other environmentally resistant material having two durometer values, and the removable design to facilitate ease of manufacture.

Known systems use a combined seal and module guide which results in a part which is difficult to manufacture and replace in the field. However, the present invention places the guide rails on the module and makes the seal much easier to fabricate and replace (if needed).

In a preferred embodiment of the seal plate member **32,** the seal plate member **34** is preferably removable and includes a mounting tongue or tang **54** at one end **56** and having an opposing end **58** adapted to be secured to the compatible module mounting assembly **24, 26** with a removable fastener **60,** such as a screw or other known fastening means cooperating with the module mounting assembly **24, 26,** and the module mounting assembly **24, 26** includes a receptacle **62** adapted to receive the finger **54** of the removable seal plate member **34.**

The known cooling systems for removable electronic units having air flow through electronics modules **10** do not provide a fixed boundary condition at the rack/module interface. The lack of this condition may cause excessive motion of the module **10** during vibration. This motion can produce fretting corrosion at the module-to-rack connector interface as well as electrical noise in sensitive electronics.

Generally, the vibration in the removable module **10** originates externally to the chassis **M** such as when the device **D** is mounted within an aircraft. The vibration is transmitted into the chassis **M** that then mechanically conveys the vibration into a mounted or connected module **10.**

In addition, the known electronics module designs include a wedge shaped sealing surface, one that is wider at the top and narrower at the bottom near the connector interface at the connector edge **18.** This taper causes misalignment and jamming of the module **10** in the rack **M** during installation. This condition can cause physical damage to the air seal and module sealing surface.

The present invention is a combined air seal, guide system, and retention method for containing cooling air between equipment racks **M** and electronics modules **10.** The guide system on the electronics module provides alignment between the electronics rack or chassis **M** and the electronic module **10** and provides protection of the sealing surfaces on the electronics module **10.** The guide system **G** is accomplished by positioning preferably two ribs **64, 66** on the module **10** to flank the air seal **36** which is installed in the electronics rack or main chassis **M.**

The electronics rack or main chassis housing **M** also contains guide rails **42a, 42b** to align the module **M** and provide a clamping surface **68.** The module ribs **64, 66** are designed to be a constant distance from the rack **M** which reduces the misalignment that is present in the known systems for cooling removable electronic units **10** that use a tapered surface. The ribs **64, 66** also protrude beyond the module **10** sealing surface **70** thus protecting the surface **70** from objects that could damage the surface **70.**

The retention or latching mechanism **72** for the module **10** within the main chassis **M** is accomplished by using a wedgelock or latch mechanism **74.** The wedgelock **74** is tightened using the fastener or lever arm **76** at the top of the removable module **10.** It thus provides a fixed structural boundary condition at the compatible and corresponding module-rack interface **24, 26** by clamping the module **10** to the rack or chassis **M.** The fixed boundary condition provides a robust design for use in high vibration applications by preventing motion of the electronics module **10** that could compromise connector interface or the air seal integrity.

The wedgelock type **74** of latching or locking mechanism **72** minimizes undesirable motion in the removable module **10** caused by vibration. RF modules **10** require stiff structures and fixed boundary interface conditions. For plug-in modules **10,** wedgelocks **74** historically have provided the best option for achieving minimal motion during dynamic conditions.

In an alternative embodiment the connection edge **18** and the electro-optical connector or plug **80** can be formed or merged with one of the mounting edges **14,16.** I such an arrangement the interconnecting plug 80 may also function as one of the ribs **64, 66.**

Vibration within an electronic device **D** of the type including a main chassis unit or electronics rack **M** and at least one compatible and removable module assembly **10** mountable with the main chassis unit **M** for supporting electronic circuitry components **78** electro-optically coupled with the main chassis unit **M** and the removable module assembly **10** that is being cooled by a cooling air flow **F** from the main chassis unit **M** about the electronic circuitry **78** can be reduced by mounting of attaching the removable module assembly **10** to at least one module mounting assembly **24** or else preferably between a pair of separated and opposing module mounting assemblies **24, 26** of the main chassis unit **M.** Alternatively, the removable module assembly **10** is ruggedized by the present invention to increase the natural frequency of the removable module **10.**

The removable module assembly **10** has a main body **12** that generally includes two opposing mounting edges **14, 16** and a connection edge **18** as described above. At least one of the mounting edges **14, 16** of the removable mounting assembly **10** includes an opening **20** or other means to vent the cooling air flow **F** into an interior cavity **22** of the main body or housing **12** of the removable module assembly **10** from the main chassis unit **M.**

At least one of the preferred pair of the opposing module mounting assemblies **24, 26** includes a plenum means **28** having an opening **30** for communicating the cooling air flow **F** into the module **10.** The module mounting assembly **24, 26** of the main chassis unit or electronics rack **M** further includes a seal plate member 32 that is preferably removable having a base plate **34** for securing to the module mounting assembly **24** of the main chassis unit **M** and an affixed elastomeric and resilient seal member **36** that is surrounding an opening **38** formed through the base plate **34** and extending from a surface **40** of the base plate **38.** The seal member **32** forms a sealing air dam about the cooling air flow **F** communicated through the plenum **28** of the module mounting assembly **24** of the main chassis unit **M.**

The module mounting assembly **24** of the main chassis unit **M** also includes a pair of guide rails **42a, 42b** extending from the module mounting assembly **24** of the main chassis unit **M** forming a U-shaped channel **44** between the pair of guide rails **42a, 42b** for receiving one of the mounting edges **14, 16** of the removable module assembly **10.** One of the mounting edges **14, 16** of the removable module assembly **10** is positioned within the compatibly formed U-shaped channel **44.** The mounting edge so positioned is then placed or maneuvered into contact with a top or upper surface **84** of the compressible and resilient seal **32** to form a sealed passageway or channel between the plenum **28** and the opening **20** for the air flow **F** to pass through from the electronics rack member **M** to the interior **22** of the module **10.**

The removable module assembly **10** further preferably includes latch means **72** for securing the removable module assembly **10** to the module mounting assembly **24** of the main chassis unit or electronics rack **M.** The removable module assembly **10** is then secured using the latch means **72** to a corresponding module mounting assembly **24** by locking one of the mounting edges of the removable module assembly **10** within the U-shaped channel **44.**

In such a series of steps, vibration in the removable mounting assembly **10** caused by the cooling air flow **F** is reduced.

Further, reducing motion enhances radar system phase noise performance during airborne operation

The foregoing disclosure and description of the invention are illustrative and explanatory thereof, and various changes in the size, shape and materials, as well as in the details of the illustrated construction may be made without departing from the invention as defined in the claims.

## Claims

1. An electronics housing system (S) adapted for electronic devices (D) of the type including a main chassis unit and at least one removable module (10) mountable with the main chassis unit (M) for supporting electronic circuitry components electro-optically coupled within the main chassis unit, comprising:
- the removable module (10) having a main body (12) including two opposing mounting edges (14, 16) and a connection edge (18); at least one of the mounting edges of the removable module (10) including an opening (20) to vent a cooling air flow into an interior cavity of the main body (12) of the removable module (10) from the main chassis unit;
- the main chassis unit (M) having a pair of separated and opposing mounting assemblies (24, 26) adapted to receive and secure a removable module (10) between the opposing mounting assemblies (24,26); at least one of the pair of the opposing mounting assemblies (24, 26) including a plenum means (28) having an opening (30) for communicating the cooling air flow into the removable module (10);
- the at least one of the pair of mounting assemblies (24, 26) of the main chassis unit further including a seal plate member (32) having a base plate (34) for securing to the at least one of the pair of mounting assemblies (24, 26) and an affixed elastomeric and resilient seal member (36) surrounding an opening (38) formed through the base plate (34) and extending from a surface of the base plate (34), the seal member forming a sealing air dam about the cooling air flow communicated through the plenum (28) of the at least one of the pair of mounting assemblies of the main chassis unit;
- the at least one of the pair of mounting assemblies (24, 26) of the main chassis unit including a pair of guide rails (42a, 42b) extending from the mounting assembly of the main chassis unit forming a U-shaped channel between the pair of guide rails for receiving at least one of the mounting edges (14, 16) of the removable module (10).
the at least one of the mounting edges of the removable module (10) further including at least one cooperating guide rail to protect a sealing surface from damage and is adapted to abut against one of the mating guide rails extending from the at least one of the pair of mounting assemblies (24, 26) of the main chassis unit when the removable module (10) is mounted within the main chassis unit,
wherein the removable module (10) further includes latch means (72) for clamping the at least one cooperating guide rail of the removable module (10) to at least one of the guide rails of the at least one of the pair of mounting assemblies (24, 26) of the main chassis unit for providing a fixed structural boundary condition between the removable module (10) and the chassis unit.

2. The system (S) of claim 1 wherein the latch means (72) for securing the removable module (10) to the at least one of the mounting assemblies (24, 26) of the main chassis unit includes a wedgelock (74).

3. The system (S) of one of the preceding claims wherein the elastomeric seal member (36) is formed from dual durometer elastomeric material.

4. The system (S) of claim 3 wherein the elastomeric seal member (36) includes an outer coating formed from a friction reducing material.

5. The system (S) of one of the preceding claims wherein the elastomeric seal member (34) is formed having a tapered cross section from a top surface to a wider base.

6. The system (S) of one of the preceding claims wherein the base plate (34) of the seal plate member is formed having an inclined upper surface with respect to a lower surface.

7. The system (S) of one of the preceding claims wherein the seal plate member is removable and includes a mounting finger at one end and having an opposing end adapted to be secured to at least one of the pair of mounting assemblies (24, 26) of the main chassis unit with a removable fastener, and the at least one of the pair of mounting assemblies (24, 26) of the main chassis unit includes a receptacle adapted to receive the finger of the removable seal plate member.

8. A method for reducing vibration within an electronic device of the type including a main chassis unit (M) and at least one removable module (10) mountable with the main chassis unit for supporting electronic circuitry components electro-optically coupled within the main chassis unit and the removable module (10) being cooled by a cooling air flow from the main chassis unit about the electronic circuitry, the invention comprising:
- mounting the removable module (10) to at least one mounting assembly (24, 26) of the main chassis unit (M);
- the removable module (10) having a main body (12) including two opposing mounting edges (14, 16) and a connection edge (18); at least one of the mounting edges (14, 16) of the removable module (10) including an opening (20) to vent the cooling air flow into an interior cavity of the main body (12) of the removable module (10) from the main chassis unit;
- the at least one of the pair of mounting assemblies (24, 26) to which the removable module (10) is mounted including a plenum means (28) having an opening (30) for communicating the cooling air flow into the removable module assembly;
- the at least one of the pair of mounting assemblies (24, 26) of the main chassis unit (M) further including a seal plate member (32) having a base plate (34) for securing to the at least one of the pair of mounting assemblies (24, 26) of the main chassis unit and an affixed elastomeric and resilient seal member surrounding an opening (38) formed through the base plate (34) and extending from a surface of the base plate, the seal member forming a sealing air dam about the cooling air flow communicated through the plenum (28) of the at least one of the pair of mounting assemblies (24, 26) of the main chassis unit;
- the at least one of the pair of mounting assemblies (24, 26) of the main chassis unit (M) including a pair of guide rails (42a, 42b) extending from the at least one of the pair of mounting assemblies (24, 26) of the main chassis unit forming a U-shaped channel between the pair of guide rails for receiving one of the mounting edges (14, 16) of the removable module (10); the removable module (10) further including latch means for securing the removable module (10) to the at least one of the pair of mounting assemblies (24, 26) of the main chassis unit;
at least one of the mounting edges of the removable module (10) further including at least one cooperating guide rail (64, 66) to protect a sealing surface from damage and is adapted to abut against one of the mating guide rails extending from the at least one of the pair of mounting assemblies (24, 26) of the main chassis unit when the removable module (10) is mounted within the main chassis unit and to provide protection of the sealing surfaces on the electronics module (10) by positioning two ribs (64, 66) to flank the air seal (36), the two module ribs designed to be at a constant distance from the rack (M) and protruding beyond the module (10) sealing surface (70) to protect said surface (70) from objects that could damage it, and
- positioning one of the mounting edges of the removable module (10) within the U-shaped channel; and
- securing the removable module (10) with the latch means to the corresponding at least one of the pair of mounting assemblies (24, 26) by clamping the at least one cooperating guide rail of the removable module (10) to at least one of the guide rails of the at least one of the pair of mounting assemblies (24, 26) of the main chassis unit for providing a fixed structural boundary condition between the removable module (10) and the chassis unit whereby vibration in the removable module (10) is reduced

9. The method of claim 8 wherein the latch means (72) for securing the removable module (10) to the at least one of the pair of mounting assemblies (24, 26) of the main chassis unit includes a wedgelock (74).

10. The method of claim 8 or 9 wherein the removable seal plate member (36) includes a mounting finger at one end and having an opposing end adapted to be secured to at least one of the pair of mounting assemblies (24, 26) of the main chassis unit with a removable fastener, and the at least one of the pair of mounting assemblies of the main chassis unit includes a receptacle adapted to receive the tang of the removable seal plate member.

## Patentansprüche

1. Elektronikgehäusesystem (S), das für elektronische Vorrichtungen (D) des Typs geeignet ist, der eine Hauptchassiseinheit und zumindest ein entfernbares Modul (10) umfasst, das zum Tragen von mit der Hauptchassiseinheit elektrooptisch gekoppelten elektronischen Schaltungskomponenten innerhalb der Hauptchassiseinheit (M) montierbar ist, umfassend:
- das entfernbare Modul (10), das einen Hauptkörper (12) aufweist, der zwei gegenüberliegende Montageränder (14, 16) und einen Verbindungsrand (18) umfasst; wobei zumindest einer der Montageränder des entfernbaren Moduls (10) eine Öffnung (20) enthält, um einen Kühlluftstrom in einen inneren Hohlraum des Hauptkörpers (12) des entfernbaren Moduls (10) von der Hauptchassiseinheit zu belüften bzw. einzuleiten;
- die Hauptchassiseinheit (M), die ein Paar getrennter und gegenüberliegender Montageanordnungen (24, 26) aufweist, die dafür geeignet sind, ein entfernbares Modul (10) zwischen den gegenüberliegenden Montageanordnungen (24, 26) aufzunehmen und zu befestigen; wobei zumindest eine des Paars der gegenüberliegenden Montageanordnungen (24, 26) ein Plenummittel (28) mit einer Öffnung (30) umfasst, um den Kühlluftstrom in das entfernbare Modul (10) zu übermitteln bzw. zu übertragen;
- wobei die zumindest eine des Paars Montageanordnungen (24, 26) der Hauptchassiseinheit ferner ein Dichtungsplattenelement (32) mit einer Basisplatte (34) zum Befestigen an der zumindest einen des Paars Montageanordnungen (24, 26) und einem angebrachten elastomeren und elastischen Dichtungselement (36) umfasst, das eine Öffnung (38) umgibt, die durch die Basisplatte (34) ausgebildet ist, und von einer Oberfläche der Basisplatte (34) ausgeht, wobei das Dichtungselement einen abdichtenden Luftdamm um den Kühlluftstrom bildet, der durch das Plenum (28) der zumindest einen des Paars Montageanordnungen der Hauptchassiseinheit übermittelt bzw. übertragen wird;
- wobei die zumindest eine des Paars Montageanordnungen (24, 26) der Hauptchassiseinheit ein Paar Führungsschienen (42a, 42b) umfasst, die von der Montageanordnung der Hauptchassiseinheit ausgehen, einen U-förmigen Kanal zwischen dem Paar Führungsschienen bildend, um zumindest einen der Montageränder (14, 16) des entfernbaren Moduls (10) aufzunehmen,
wobei der zumindest eine der Montageränder des entfernbaren Moduls (10) ferner zumindest eine zusammenwirkende Führungsschiene umfasst, um eine abdichtende Oberfläche vor Beschädigung zu schützen, und dafür geeignet ist, an einer der zusammenpassenden Führungsschienen anzuliegen, die von der zumindest einen des Paars Montageanordnungen (24, 26) der Hauptchassiseinheit ausgehen, wenn das entfernbare Modul (10) innerhalb der Hauptchassiseinheit montiert ist,
wobei das entfernbare Modul (10) ferner ein Verriegelungsmittel (72) umfasst, um die zumindest eine zusammenwirkende Führungsschiene des entfernbaren Moduls (10) an zumindest eine der Führungsschienen der zumindest einen des Paars Montageanordnungen (24, 26) der Hauptchassiseinheit zu klemmen, um eine feste strukturelle Randbedingung zwischen dem entfernbaren Modul (10) und der Chassiseinheit vorzusehen.

2. System (S) nach Anspruch 1, wobei das Verriegelungsmittel (72) zum Befestigen des entfernbaren Moduls (10) an der zumindest einen der Montageanordnungen (24, 26) der Hauptchassiseinheit eine Keilverriegelung bzw. einen Wedgelock (74) umfasst.

3. System (S) nach einem der vorhergehenden Ansprüche, wobei das elastomere Dichtungselement (36) aus einem elastomeren Dual-Durometermaterial gebildet ist.

4. System (S) nach Anspruch 3, wobei das elastomere Dichtungselement (36) eine äußere Beschichtung aufweist, die aus einem Reibung reduzierenden Material gebildet ist.

5. System (S) nach einem der vorhergehenden Ansprüche, wobei das elastomere Dichtungselement (34) mit einem verjüngten Querschnitt von einer Oberseite zu einer breiteren Basis ausgebildet ist.

6. System (S) nach einem der vorhergehenden Ansprüche, wobei die Basisplatte (34) des Dichtungsplattenelements mit einer geneigten oberen Oberfläche bezüglich einer unteren Oberfläche ausgebildet ist.

7. System (S) nach einem der vorhergehenden Ansprüche, wobei das Dichtungsplattenelement entfernbar ist und einen Montagefinger an einem Ende umfasst und ein gegenüberliegendes Ende aufweist, das dafür geeignet ist, an zumindest einer des Paars Montageanordnungen (24, 26) der Hauptchassiseinheit mit einem entfernbaren Befestigungsmittel befestigt zu werden, und die zumindest eine des Paars Montageanordnungen (24, 26) der Hauptchassiseinheit eine Aufnahme umfasst, die dafür geeignet ist, den Finger des entfernbaren Dichtungsplattenelements aufzunehmen.

8. Verfahren zum Reduzieren einer Vibration innerhalb einer elektronischen Vorrichtung des Typs, der eine Hauptchassiseinheit (M) und zumindest ein entfernbares Modul (10) umfasst, das zum Tragen von innerhalb der Hauptchassiseinheit elektrooptisch gekoppelten elektronischen Schaltungskomponenten mit der Hauptchassiseinheit montierbar ist, und wobei das entfernbare Modul (10) durch einen Kühlluftstrom von der Hauptchassiseinheit um die elektronische Schaltungsanordnung gekühlt wird, wobei die Erfindung umfasst:
Montieren des entfernbaren Moduls (10) an zumindest einer Montageanordnung (24, 26) der Hauptchassiseinheit (M);
- wobei das entfernbare Modul (10) einen Hauptkörper (12) aufweist, der zwei gegenüberliegende Montageränder (14, 16) und einen Verbindungsrand (18) umfasst; wobei zumindest einer der Montageränder (14, 16) des entfernbaren Moduls (10) eine Öffnung (20) enthält, um den Kühlluftstrom in einen inneren Hohlraum des Hauptkörpers (12) des entfernbaren Moduls (10) von der Hauptchassiseinheit zu belüften bzw. einzuleiten;
- wobei die zumindest eine des Paars Montageanordnungen (24, 26), an der das entfernbare Modul (10) montiert wird, ein Plenummittel (28) mit einer Öffnung (30) zum Übermitteln bzw. Übertragen des Kühlluftstroms in die entfernbare Modulanordnung umfasst;
- wobei die zumindest eine des Paars Montageanordnungen (24, 26) der Hauptchassiseinheit (M) ferner ein Dichtungsplattenelement (32) mit einer Basisplatte (34) zum Befestigen an der zumindest einen des Paars Montageanordnungen (24, 26) der Hauptchassiseinheit und einem angebrachten elastomeren und elastischen Dichtungselement umfasst, das eine Öffnung (38) umgibt, die durch die Basisplatte (34) ausgebildet ist, und von einer Oberfläche der Basisplatte ausgeht, wobei das Dichtungselement einen abdichtenden Luftdamm um den Kühlluftstrom bildet, der durch das Plenum (28) der zumindest einen des Paars Montageanordnungen (24, 26) der Hauptchassiseinheit übertragen bzw. übermittelt wird;
- wobei die zumindest eine des Paars Montageanordnungen (24, 26) der Hauptchassiseinheit (M) ein Paar Führungsschienen (42a, 42b) umfasst, die von der zumindest einen des Paars Montageanordnungen (24, 26) der Hauptchassiseinheit ausgehen, einen U-förmigen Kanal zwischen dem Paar Führungsschienen bildend, um einen der Montageränder (14, 16) des entfernbaren Moduls (10) aufzunehmen; wobei das entfernbare Modul (10) ferner Verriegelungsmittel zum Befestigen des entfernbaren Moduls (10) an der zumindest einen des Paars Montageanordnungen (24, 26) der Hauptchassiseinheit umfasst;
wobei zumindest einer der Montageränder des entfernbaren Moduls (10) ferner zumindest eine zusammenwirkende Führungsschiene (64, 66), umfasst, um eine abdichtende Oberfläche vor Beschädigung zu schützen, und dafür geeignet ist, an einer der zusammenpassenden Führungsschienen anzuliegen, die von der zumindest einen des Paars Montageanordnungen (24, 26) der Hauptchassiseinheit ausgehen, wenn das entfernbare Modul (10) innerhalb der Hauptchassiseinheit montiert ist, und einen Schutz der abdichtenden Oberflächen auf dem Elektronikmodul (10) vorzusehen, indem zwei Rippen (64, 66) positioniert sind, um die Luftdichtung (36) zu flankieren, wobei die beiden Modulrippen so entworfen sind, dass sie sich bei einer konstanten Distanz vom Rack (M) befinden und über die abdichtende Oberfläche (70) des Moduls (10) hinaus ragen, um die Oberfläche (70) vor Objekten zu schützen, die sie beschädigen könnten; und
- Positionieren eines der Montageränder des entfernbaren Moduls (10) innerhalb des U-förmigen Kanals; und
- Befestigen des entfernbaren Moduls (10) mit dem Verriegelungsmittel an der entsprechenden zumindest einen des Paars Montageanordnungen (24, 26), indem die zumindest eine zusammenwirkende Führungsschiene des entfernbaren Moduls (10) an zumindest eine der Führungsschienen der zumindest einen des Paars Montageanordnungen (24, 26) der Hauptchassiseinheit geklemmt wird, um eine feste strukturelle Randbedingung zwischen dem entfernbaren Modul (10) und der Chassiseinheit vorzusehen, wobei eine Vibration im entfernbaren Modul (10) reduziert wird.

9. Verfahren nach Anspruch 8, wobei das Verriegelungsmittel (72) zum Befestigen des entfernbaren Moduls (10) an der zumindest einen des Paars Montageanordnungen (24, 26) der Hauptchassiseinheit eine Keilverriegelung bzw. einen Wedgelock (74) umfasst.

10. Verfahren nach Anspruch 8 oder 9, wobei das entfernbare Dichtungsplattenelement (36) einen Montagefinger an einem Ende umfasst und ein gegenüberliegendes Ende aufweist, das dafür geeignet ist, an der zumindest einen des Paars Montageanordnungen (24, 26) der Hauptchassiseinheit mit einem entfernbaren Befestigungsmittel befestigt zu werden, und die zumindest eine des Paars Montageanordnungen der Hauptchassiseinheit eine Aufnahme umfasst, die dafür geeignet ist, den Finger bzw. Zapfen des entfernbaren Dichtungsplattenelements aufzunehmen.

## Revendications

1. Système de boîtier électronique (S) adapté à des dispositifs électroniques (D) du type comprenant une unité de châssis principale et au moins un module amovible (10) apte à être monté sur l'unité de châssis principale (M) pour supporter des composants de circuit électronique reliés par voie électro-optique dans ladite unité de châssis principale, comprenant :
- le module amovible (10), qui comporte un corps principal (12) présentant deux bords de montage opposés (14, 16) et un bord de liaison (18) ; l'un au moins des bords de montage du module amovible (10) présentant une ouverture (20) pour amener un flux d'air de refroidissement dans une cavité intérieure du corps principal (12) du module amovible (10) à partir de l'unité de châssis principale ;
- l'unité de châssis principale (M) comportant deux ensembles de montage (24, 26), séparés et opposés, aptes à recevoir et à bloquer entre eux un module amovible (10) ; l'un au moins de ces deux ensembles de montage opposés (24, 26) comportant des moyens de répartition d'air (28) qui présentent une ouverture (30) pour amener le flux d'air de refroidissement dans le module amovible (10) ;
- le ou les ensembles de montage (24, 26) de l'unité de châssis principale comprenant également un élément à plaque d'étanchéité (32) qui comporte une plaque de base (34) à fixer à l'ensemble ou aux ensembles de montage (24, 26), et un élément d'étanchéité élastomère et résilient fixe (36) qui entoure une ouverture (38) formée dans la plaque de base (34) et s'étendant à partir d'une surface de cette dernière, l'élément d'étanchéité formant une barrière d'étanchéité autour du flux d'air de refroidissement qui traverse l'espace de répartition d'air (28) de l'ensemble ou des ensembles de montage de l'unité de châssis principale ;
- le ou les ensembles de montage (24, 26) de l'unité de châssis principale comprenant deux rails de guidage (42a, 42b) qui s'étendent à partir de l'ensemble de montage de l'unité de châssis principale en formant entre eux un passage en U pour recevoir l'un au moins des bords de montage (14, 16) du module amovible (10) ;
le ou les bords de montage du module amovible (10) comprenant également au moins un rail de guidage associé, pour protéger une surface d'étanchéité de dégradations, et est apte à buter contre l'un des rails de guidage associés qui s'étendent à partir de l'ensemble ou des ensembles de montage (24, 26) de l'unité de châssis principale quand le module amovible (10) est monté dans ladite unité de châssis principale,
le module amovible (10) comprenant également des moyens de verrouillage (72) pour serrer le ou les rails de guidage associés du module amovible (10) sur l'un au moins des rails de guidage de l'un au moins des deux ensembles de montage (24, 26) de l'unité de châssis principale, pour former une condition de limite structurelle fixe entre le module amovible (10) et l'unité de châssis.

2. Système (S) de la revendication 1, dans lequel les moyens de verrouillage (72) pour fixer le module amovible (10) à l'ensemble ou aux ensembles de montage (24, 26) de l'unité de châssis principale comprennent un coin de blocage (74).

3. Système (S) des revendications précédentes, dans lequel l'élément d'étanchéité élastomère (36) est formé à partir d'un matériau élastomère à double duromètre.

4. Système (S) de la revendication 3, dans lequel l'élément d'étanchéité élastomère (36) comprend un revêtement extérieur formé à partir d'un matériau réduisant le frottement.

5. Système (S) des revendications précédentes, dans lequel l'élément d'étanchéité élastomère (34) est formé avec une section transversale effilée, d'une surface supérieure jusqu'à une base plus large.

6. Système (S) des revendications précédentes, dans lequel la plaque de base (34) de l'élément à plaque d'étanchéité est formée avec une surface supérieure inclinée par rapport à une surface inférieure.

7. Système (S) des revendications précédentes, dans lequel l'élément à plaque d'étanchéité est amovible et comprend à une extrémité une saillie de montage, et une extrémité opposée apte à être fixée à l'un au moins des deux ensembles de montage (24, 26) de l'unité de châssis principale à l'aide d'une fixation amovible, et le ou les ensembles de montage (24, 26) de l'unité de châssis principale comprennent un réceptacle apte à recevoir ladite saillie de l'élément à plaque d'étanchéité amovible.

8. Procédé pour réduire les vibrations dans un dispositif électronique du type comprenant une unité de châssis principale et au moins un module amovible (10) apte à être monté sur l'unité de châssis principale (M) pour supporter des composants de circuit électronique reliés par voie électro-optique dans ladite unité de châssis principale, et le module amovible (10) étant refroidi par un flux d'air de refroidissement à partir de l'unité de châssis principale, autour du circuit électronique, l'invention comprenant :
- le montage du module amovible (10) sur au moins un ensemble de montage (24, 26) de l'unité de châssis principale (M) ;
- le module amovible (10) comportant un corps principal (12) présentant deux bords de montage opposés (14, 16) et un bord de liaison (18) ; l'un au moins des bords de montage du module amovible (10) présentant une ouverture (20) pour amener le flux d'air de refroidissement dans une cavité intérieure du corps principal (12) du module amovible (10) à partir de l'unité de châssis principale ;
- le ou les ensembles de montage (24, 26) sur lesquels le module amovible (10) est monté comportant des moyens de répartition d'air (28) qui présentent une ouverture (30) pour amener le flux d'air de refroidissement dans le module amovible (10) ;
- le ou les ensembles de montage (24, 26) de l'unité de châssis principale (M) comprenant également un élément à plaque d'étanchéité (32) qui comporte une plaque de base (34) à fixer à l'ensemble ou aux ensembles de montage (24, 26) de ladite unité de châssis principale (M), et un élément d'étanchéité élastomère et résilient fixe qui entoure une ouverture (38) formée dans la plaque de base (34) et s'étendant à partir d'une surface de cette dernière, l'élément d'étanchéité formant une barrière d'étanchéité autour du flux d'air de refroidissement qui traverse l'espace de répartition d'air (28) de l'ensemble ou des ensembles de montage (24, 26) de l'unité de châssis principale ;
- le ou les ensembles de montage (24, 26) de l'unité de châssis principale (M) comprenant deux rails de guidage (42a, 42b) qui s'étendent à partir de l'ensemble ou des ensembles de montage (24, 26) de l'unité de châssis principale en formant entre eux un passage en U pour recevoir l'un des bords de montage (14, 16) du module amovible (10) ; le module amovible (10) comprenant également des moyens de verrouillage (72) pour fixer le module amovible (10) à l'ensemble ou aux ensembles de montage (24, 26) de l'unité de châssis principale ;
l'un au moins des bords de montage du module amovible (10) comprenant également au moins un rail de guidage associé (64, 66) pour protéger une surface d'étanchéité de dégradations, et est apte à buter contre l'un des rails de guidage associés qui s'étendent à partir de l'ensemble ou des ensembles de montage (24, 26) de l'unité de châssis principale quand le module amovible (10) est monté dans ladite unité de châssis principale, et pour prévoir une protection des surfaces d'étanchéité sur le module électronique (10) en plaçant deux rebords (64, 66) de part et d'autre du joint d'étanchéité à l'air (36), les deux rebords de module étant conçus pour se trouver à une distance constante du châssis (M), et dépassant de la surface d'étanchéité (70) du module (10) pour protéger ladite surface (70) d'objets qui pourraient l'abîmer ; et
- le positionnement de l'un des bords de montage du module amovible (10) dans le passage en U ; et
- la fixation du module amovible (10), à l'aide des moyens de verrouillage, à l'ensemble correspondant ou aux ensembles de montage (24, 26), en serrant le ou les rails de guidage associés dudit module amovible (10) sur l'un au moins des rails de guidage de l'ensemble ou des ensembles de montage (24, 26) de l'unité de châssis principale, pour former une condition de limite structurelle fixe entre le module amovible (10) et l'unité de châssis, moyennant quoi les vibrations dans ledit module amovible (10) sont réduites.

9. Procédé de la revendication 8, dans lequel les moyens de verrouillage (72) pour fixer le module amovible (10) à l'ensemble ou aux ensembles de montage (24, 26) de l'unité de châssis principale comprennent un coin de serrage (74).

10. Procédé de la revendication 8 ou 9, dans lequel l'élément à plaque d'étanchéité amovible (36) comprend à une extrémité une saillie de montage, et une extrémité opposée apte à être fixée à l'un au moins des deux ensembles de montage (24, 26) de l'unité de châssis principale à l'aide d'une fixation amovible, et le ou les ensembles de montage (24, 26) de l'unité de châssis principale comprennent un réceptacle apte à recevoir ladite saillie de l'élément à plaque d'étanchéité amovible.
